# EUROPEAN PATENT SPECIFICATION

(11) **EP 4 194 758 B1**
(45) Date of publication and mention of the grant of the patent: **04.06.2025**
(21) Application number: 21383124.1
(22) Date of filing: 10.12.2021
(51) Int. Cl.: F24C 7/08, A47L 15/42, D06F 34/28, H05B 6/64, H05K 1/02

(54) **ELECTRICAL DOMESTIC APPLIANCE WITH AN OPERATING DEVICE**
ELEKTRISCHES HAUSHALTSGERÄT MIT EINER BEDIENVORRICHTUNG
APPAREIL ÉLECTRIQUE DOMESTIQUE AVEC UN DISPOSITIF DE COMMANDE

(43) Date of publication of application: 14.06.2023
(73) Proprietor: E.G.O. Elektro-Gerätebau GmbH, 75038 Oberderdingen (DE)
(72) Inventor: Gutierrez, Manolo, 08360 Canet de Mar (ES); Gonzalez, Orlando, 08172 Sant Cugat del Valles (ES); Gamiz, Francesc, 08530 La Garriga (ES)
(74) Representative: Patentanwälte Ruff, Wilhelm, Beier, Dauster & Partner mbB

(56) References cited:
- EP-A1- 2 689 642
- DE-A1- 102011 004 174
- DE-A1- 102015 214 882
- DE-B3- 102020 211 730
- DE-U1- 202015 106 042
- FR-A1- 2 895 047

## Description

### Field of application and prior art

The invention is directed to an electrical domestic or household appliance having an operating device.

An operating device of this kind is known from EP 859 467 A1, for example, which provides several touch switch functions as well as a display device for a user to easily and comfortably operate the appliance. Sensor elements for the touch switch functions are provided on a printed circuit board. The printed circuit board is held by a holding device in the appliance such that it can move somewhat or is held elastically in place.

It is known from DE 10 2020 211 730 B3 to provide a housing for a printed circuit board, which PCB carries an electronic circuit. The purpose of the arrangement of the PCB in the housing is only to protect the PCB on the one hand against dirt or damage. On the other hand, as is defined in paragraph [0009], the position of the PCB in the housing shall be fixed and static to a high degree.

It is known from DE 20 2015 106 042 U1 to provide a housing for a printed circuit board, where according to paragraph [0007], a thermal contact between the PCB and the housing shall be very good. The PCB itself is provided with elastic arms, which serve to press a continuous lateral edge of the PCB into a corresponding U-shaped slit on the inside of the housing. This is the place where the high thermal conductivity shall be established.

It is known from EP 2 689 642 A1 to provide a carrier for LEDs, on which a plurality of LEDs may be provided. The carrier can be partly cut by longitudinal, slit-like through-holes. They serve to provide a movability of contact pads for the LED relative to each other.

It is known from DE 10 2011 004 174 A1 to provide cutouts or slits in a printed circuit board. This serves to bend a part of the PCB upwards. Their shapes vary to a large degree.

It is further known from DE 10 2015 214 882 A1 to provide an operating device in a household appliance such as a cooling hob. The operating device has a housing, which is pressed against the underside of a cooking hob plate by metallic springs. Inside the housing, a printed circuit board is provided carrying control parts and capacitive sensor elements. To press the PCB with the capacitive sensor elements elastically against the underside of the cooking hob plate, metallic leave springs are provided in the housing.

### Object and solution

It is an object of the invention at hand to provide an appliance with an operating device with which problems of the prior art can be solved or avoided and which in particular is of simple construction and can be manufactured easily.

This object is achieved with an electrical domestic or household appliance having the features of claim 1. Advantageous and preferred embodiments of the invention are the subject-matter of the sub-claims and are explained in detail hereinafter. Some of the features of the invention are described only with regard to the operating device or only with regard to the electrical appliance. They shall, however, independently of this, be applicable to such an electrical appliance. The wording of the claims is made part of the description herewith by explicit reference.

The operating device comprises a printed circuit board, also called PCB, with electrical components thereon, for example resistors, microcontrollers or SMD parts. The printed circuit board has at least one holding section, preferably three or four holding sections. The operating device also comprises a holding device for the printed circuit board to hold it positively and fixedly. The holding device engages the at least one holding section or every holding section of the printed circuit board such that the printed circuit board is held on or by the holding device by means of the at least one holding section. The holding section may be screwed or glued to the holding device, alternatively it may be held in a positive form by a latching mechanism or the like.

According to the invention, the at least one holding section is integrally formed out of the printed circuit board by at least one cut through the printed circuit board. The cut may separate the at least one holding section or every holding section at least partially from the remaining printed circuit board. This means that in any way the holding section has been part of the printed circuit board at least before this has been cut into form. Preferably, the holding section is in the same plane as the remaining circuit board. This serves for easy manufacture of the printed circuit board as well as a firm and lasting connection of the holding section to the remaining printed circuit board. The at least one holding section or every holding section is integral with and integrally connected in one piece to the remaining printed circuit board. This in particular means that the holding section has not been affixed or somehow mounted to the remaining printed circuit board as an originally separate part but is an integral part of the board. Furthermore, the holding section has at least one free holding end region, particularly only exactly one free holding end region. The free holding end region is elastically movable relative to the remaining printed circuit board in a direction perpendicular to the surface of the remaining printed circuit board. This is the direction into which the printed circuit board can move elastically or is movable, for example for 1 mm to 3 mm or even as much as 5 mm.

The integral provision of holding sections for the printed circuit board, which allow an elastic and movable fixture of the printed circuit board in the operating device, saves the step of mounting or providing another additional elastic holder or the like.

In an embodiment of the invention, the holding section may be in elongate form. Preferably the holding section has a length, which is at least three times or at least ten times the width of the holding section. Particularly, the holding section may have a constant width. In addition, the free holding end region may be provided at the end of the length of the holding section, thus allowing the free holding end to be the part which can move furthest along the direction perpendicular to the printed circuit board. In a preferred manner, the holding device holds the printed circuit board at the free holding end region of the holding section.

In a further embodiment of the invention, the cut runs in a direction parallel to the longitudinal direction of the holding section. This allows for the holding section to have a constant width. Furthermore, the curvature of the holding section when it is elastically deflected away from the plane of the printed circuit board is rather constant or equally distributed, respectively.

In a preferred embodiment of the invention the holding section is separated from the remaining printed circuit board by means of exactly one single and straight cut between the holding section and the remaining printed circuit board. In particular, this single straight cut begins at a free outer edge of the printed circuit board and may then run parallel to a further outer edge of the printed circuit board which is angularly adjacent. This further outer edge may also be a longitudinal side of the holding section. By this, only one cut needs to be made, and the result is a holding section having a constant width.

In an alternative embodiment of the invention the holding section is separated from the remaining printed circuit board by means of two cuts between the holding section and the remaining printed circuit board, wherein the two cuts may form a rectangle or trapezoid. In this case, the holding section may protrude from the printed circuit board

In a further alternative embodiment of the invention, the holding section can be separated from the remaining printed circuit board by at least two cuts. It is possible for the two cuts to start at an outer edge of the printed circuit board, wherein the two cuts may be parallel to one another. The end edge of the free outer end region of this holding section may be formed by the outer edge mentioned before. However, this is only the case if this holding section reaches out to the outer contour of the remaining printed circuit board.

In another embodiment of the invention, a holding section may have at least two partial holding sections being connected with each other, wherein it may be formed by the at least two cuts mentioned before. Preferably, the two partial holding sections are running along different directions, for example 90° or 180°. Furthermore, the holding section may have at least as many free cuts as such partial holding sections. This allows for the active length of the holding section, wherein the length is delimited on the one hand by the free holding end region and on the other hand by being connected to the printed circuit board, to be longer than the longitudinal extension of the holding section along one straight direction.

Preferably, one of the two cuts mentioned before may be longer than the other cut and extend with a longitudinal region. This longitudinal region may extend beyond the other cut in a curved manner. This may particularly be a part-circle shape and may be arranged in a region at the end of the other cut. A circular angle may be at most 180°.

It may further be provided that one of the two cuts for making the holding section can be longer than the other cut. Furthermore, the one cut, preferably also the other cut, may extend beyond the other cut. This may be made in a curved manner or, for example, in a part-circle shape and around a region at the end of the other cut. Preferably, there may be provided a circular angle of at most 180°.

In a further embodiment of the invention, the holding section may be arranged within the surface or the boundary of the printed circuit board without being connected to an outer edge of the printed circuit board or having a distance of at least 0.5 cm to each of the outer edges or boundaries of the printed circuit board. In a preferred manner, at least two such cuts, which are parallel, may delimit the holding section along its longitudinal edges. In particular, these at least two cuts may be parallel.

In a preferred embodiment of the invention, the at least one holding section or every holding section has a substantially rectilinear extension, preferably as a long rectangle. The width of the holding section is in particular constant.

As an alternative or in addition, at least one holding section may have a rounded and curved shape, preferably being made up of two partial holding sections mentioned before. This shape could for example be a U-shape or a J-shape. Also this holding section may have a constant width. The rounded form or curve may be at an angle of 180°. Such a curving can lend the holding section even more flexibility for a more flexible or soft spring property.

As a further alternative or additionally at least one holding section can be meander-shaped with partial holding sections that are adjacent to each other and/or parallel to each other. These partial holding sections should be arranged at a small distance from one another and run in opposite directions. The number of partial holding sections forming the meander-shape can be at least three and up to five or six partial holding sections. At one end this meander-shape is integral with the printed circuit board, and its other end is the free holding end region mentioned before.

In the invention, a carrier device for a flat sensor element carrier is provided on the printed circuit board. This sensor element carrier is arranged parallel to the printed circuit board and at some distance therefrom, for example between 1 cm and 5 cm. The sensor element carrier can have a carrier holder which again is mounted onto the printed circuit board. The operating device is pressed against an operating panel which is part of the electrical household or domestic appliance. If the sensor element carrier has capacitive sensor elements on its upper side, they may form touch switches together with the operating panel as is known in the art. This pressing of the sensor element carrier against the operating panel should also be in elastic manner, which is another reason why it is preferred to hold the printed circuit board carrying the sensor element carrier in elastic manner by the elastically movable holding sections. This allows for the sensor element carrier being mounted onto the printed circuit board in non-elastic manner. As an alternative not part of the invention, also the sensor element carrier could be designed in such a way with elastically movable holding sections. The electrical components provided on the printed circuit board which have been mentioned in the beginning would then be formed by the sensor elements, preferably in the form of flat metallic surfaces.

In a further option of the invention, the printed circuit board can have three or four holding sections. Preferably the printed circuit board is basically in the shape of a rectangle such that the holding sections can and should be arranged in corner regions. If the printed circuit board is larger than for example 10 cm in length and/or width, another holding section can be provided in a center region of it. This further holding section should then be formed as explained before with some distance to an outer edge of the printed circuit board. In addition, it may be formed in a rounded curved shape or a meander-shape.

The electrical household or domestic appliance according to the invention is provided with an operating device as described before. The appliance has a cover being regarded as the operating panel for the operating device mentioned before. This cover may be a front face in the case of a baking oven or the like. Alternatively, it may be a cooktop plate in the case of a cooktop. The operating panel furthermore has an outer side for operation, for example for touching with a finger to operate touch switches provided at this place. The operating device is arranged on the rear or inner side of the operating panel and is preferably pressed against this rear side, most preferably with the capacitive sensor elements mentioned before. The at least one elastically movable holding section of the printed circuit board, in particular every elastically movable holding section, is displaced or deflected by movement of the printed circuit board with respect to the holding device for it in the mounted state of the operating device in the appliance. This means that the at least one holding section is somewhat pre-stressed by mounting the operating device in the appliance such that the operating device is elastically pressed with some force against the rear side of the operating panel.

### Short description of the drawings

In the following, embodiments of the invention will be described in detail with reference to the drawings. In the drawings show:
- Fig. 1: a top view onto a printed circuit board PCB according to the invention with four cuts forming four holding sections,
- Fig. 2: a side view onto the PCB of Fig. 1 with electrical components on it and with the holding sections in the state of being deflected upwards in dashed lines,
- Fig. 3: an operating device according to the invention with the PCB of Fig. 1 in a baking oven as appliance according to the invention, and
- Fig. 4: a top view onto various possible embodiments of a PCB with different holding sections.

### Detailed description of the embodiments

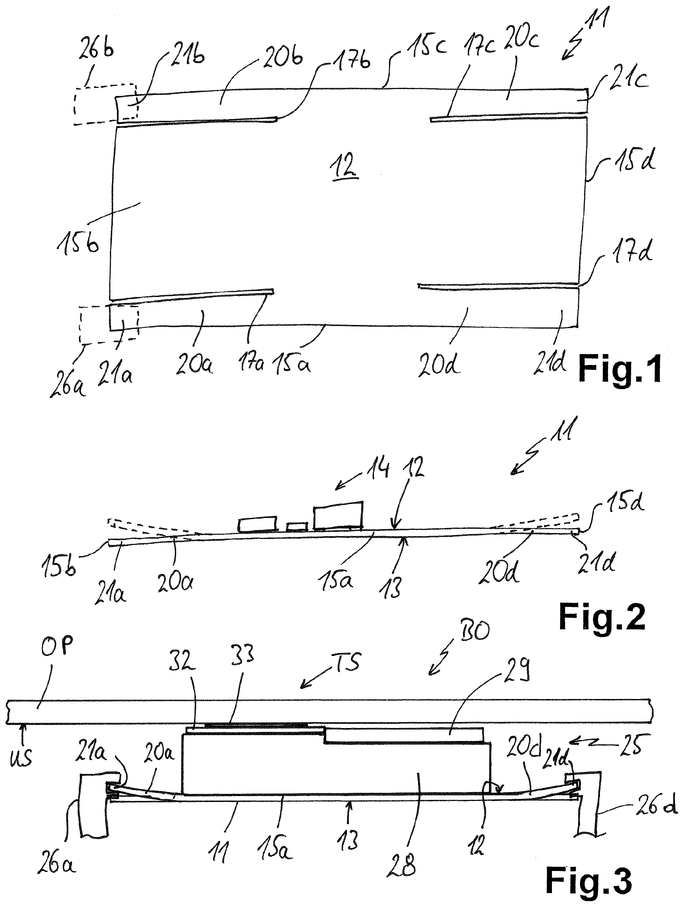

In fig. 1, a top view onto a PCB 11 according to the invention is shown. The basic shape of this PCB 11 is rectangular. The material of the PCB 11 is conventional material as described before, preferably made of glass fiber and resin. As can also be taken from fig. 2, the PCB 11 has an upper side 12 and an underside 13. Electrical components 14 are shown in fig. 2 as an example. They could be provided also on the underside 13, as an alternative only on the underside 13. The PCB 11 is provided with conductor paths as is conventional in the art. Some of the electrical components 14 could also be connecting elements or plug connectors, respectively. PCB 11 has four edges 15a, 15b, 15c and 15d. In the edge regions of PCB 11, four straight cuts 17a, 17b, 17c and 17d are provided that have been made into the material. They are each parallel to each other with similar length and similar distance to one of the edges 15 being parallel and closest to it. The cuts 17 may have a width of less than 1 mm such that they are not Fnly simply cut with a knife or the like, but some of the material of PCB 11 is removed to form a true gap in PCB 11, for example with a laser. The width of the cuts 17 can for example be between 0.1 mm and 1 mm.

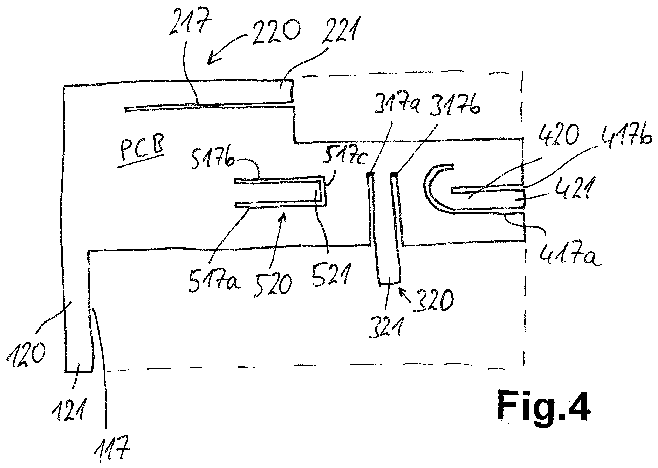

By providing the cuts 17 into PCB 11, four holding sections 20a, 20b, 20c and 20d in the inventive kind are formed. They are connected to the rest of the PCB 11 in a region where the cuts 17 end, which is clearly shown. At the opposite end of the holding sections 20, end regions 21a, 21b, 21c and 21d are formed. These are the free ends of the holding sections 20. As is shown by the dashed lines in the end regions 21a and 21b, holders 26a and 26b can positively and fixedly hold each of the holding sections 20a and 20b. The holders 26 need not necessarily hold the holding sections at the free ends or end regions 21, respectively. It is obvious that the elastic properties of the holding sections 20 are best in these end regions 21, and a distance about which the PCB 11 can be deflected is the largest. Various other forms for the cuts 17 and the holding sections 20 are possible, as has been described before and is shown in further detail in fig. 4.

Fig. 3 shows a cut through a baking oven BO as an electrical domestic appliance according to the invention, but only a part of such a baking oven, in particular a part of the front. Baking oven BO has an operating panel OP, for example made of at least partly transparent glass or the like. The operating panel OP has an underside US against which an operating device 25 is elastically pressed. The operating device 25 has a PCB 11 according to figs. 1 and 2. It is shown that the holding sections 20a and 20d are held with their respective end regions 21a and 21d by holders 26a and 26d in a positive and fixed manner. Details for the holders 26 need not be described here, but are simple and plain for a person skilled in the art. It is shown in fig. 3 that the holding sections 20a and 20d as well as the others are deflected upwards as their end regions 21 are held in place in a defined position by the holders 26.

On the upper side 12 of PCB 11 a carrier device 28 is placed, preferably among other electrical components which are not shown in fig. 3. The carrier device 28 carries on its topside an LC-display 29. The operating panel OP should be at least transparent above this LC-display 29 to be visible for a user.

Next to the LC-display 29, a sensor PCB 32 is held on the carrier device 28. This sensor PCB 32 has several sensor elements 33 on its upper side. The sensor elements 33 are electrically conductive fields, preferably made of a copper plating on the sensor PCB 32. They are electrically connected in a manner not shown here to the PCB 11 for the sensing function. The sensor elements 33 are also pressed against the underside US of the operating panel OP. In known manner, they form touch switches TS for the operating device 25 of the baking oven BO. A user can put a finger onto these touch switches TS, which is then detected and an operating function or switching function, respectively, can be effected.

It is paramount for the sensor elements 33 to be pressed against the underside US for proper and reliable function of the touch switches TS. They should be pressed against the operating panel OP in an elastic manner, for which in the prior art metal springs or the like have been used. As can be taken from fig. 3, this elastic or spring function is provided for by the elastic holding sections 20. The elasticity comes from the material of the PCB 11 and the long and narrow form of the holding sections 20. This has the advantage that no further separate means or parts such as metal springs or the like need to be provided, which would mean in consequence additional effort when assembling the operating device 25 or the whole baking oven BO, respectively. The holders 26 could be part of a larger structure inside the baking oven BO.

A deflection of the holding sections 20 could be for example only a few millimeters, for example 1 mm to 3 mm. Alternatively, the deflection could generally be between 1% and 10% of the length of the holding sections. Another advantageous aspect is, as can be taken from fig. 1, to provide holding sections in a distributed manner, preferably roughly equally distributed. If, however, an elastic mounting is only important in one side region or corner region of such a PCB, an elastic holding section could be provided only in this region.

From fig 4 several alternative embodiments for holding sections are shown. In practice, they would not all be provided on one single PCB, so this is only an example.

One holding section 120 could be provided in such a way that it does not have a narrow cut separating it from the rest of the PCB, but it can protrude largely away from the remaining PCB.

A free holding end region 121 is consequently far away from any other part or region of the PCB. As can be taken from the dashed lines, a large part of an originally rectangular PCB has been cut away by a kind of cut 117 to fabricate the holding section 120.

Another holding section 220 is separated by one cut 217 from the rest of the PCB and is much closer to the PCB than holding section 120. Contrary to the holding sections of fig. 1, the region where the holding sections 220 is connected to the PCB is in a corner of the PCB, whereas a free holding end region 221 is rather closer to a central area of the PCB. This holding section 220 provides for the elasticity or flexibility for the PCB rather at the outer corners of the PCB, wherein the holding sections 20 provide for the elasticity or flexibility for the PCB rather at a central area of the PCB.

Another holding section 320 is formed by two cuts 317a and 317b instead of only one, and they have the same length. It is protruding somewhat over an outer edge of the PCB and runs at an angle of about 90° to this edge. A free holding end region protrudes with about a third of the length of the holding section 320 over this outer edge. Also this holding section 320 provides for the elasticity or flexibility for the PCB rather at a central area of the PCB.

A further holding section 420 is formed by two cuts 417a and 417b into the PCB. The cut 417a is longer than the other cut 417b and is bent around the inner end of this cut 417b. Preferably, the inner end of the cut 417a has a curvature with a radius of the distance between the cuts 417a and 417b corresponding to the width of the holding section 420, and its center point is the inner end of the cut 417b. This serves for an elasticity not only along the length of the holding section 420 but provides for additional elasticity by the special form of the bent inner end of the holding section 420. The free end of the holding section 420 is along the outer edge of the PCB. It can easily be conceived how a meander form of a holding section could be provided for by forming the two cuts along the holding section being provided or bent in an alternating way.

Another holding section 520 is formed by three cuts 517a, 517b and 517c into the PCB. The holding section 520 is situated completely inside the PCB, in this case even in a rather central area of the PCB. The free holding end region 521 does not reach to any of the outer edges of the PCB. It may be somewhat more difficult to fix the free holding end regions 521 of the holding section 520 to a holding device, but it is still possible.

## Claims

1. Electrical domestic or household appliance (BO) having an operating device (25), the operating device (25) comprising:
- a printed circuit board (11) with electrical components (14) thereon, the printed circuit board (11) having at least one holding section (20, 120, 220, 320, 420, 520),
- a holding device (26) for the printed circuit board (11), the printed circuit board (11) being positively and fixedly held on the holding device (26), the holding device (26) engaging the at least one holding section (20, 120, 220, 320, 420, 520) of the printed circuit board (11) and the printed circuit board (11) being held on the holding device (26) by means of the at least one holding section (20, 120, 220, 320, 420, 520),
wherein:
- the electrical domestic or household appliance (BO) has a cover as an operating panel (OP) for the operating device (25),
- the operating panel (OP) has a front side for operation and has a rear side (US),
- the operating device (25) is arranged on the rear side (US) of the operating panel (OP),
- a carrier device (28) holding a flat sensor element carrier (32) is provided on the printed circuit board (11),
- the sensor element carrier (32) is arranged parallel to the printed circuit board (11) and at a distance therefrom,
- the sensor element carrier (32) is pressed against a rear side (US) of the operating panel (OP) of the operating device (25), **characterized in that**
- the at least one holding section (20, 120, 220, 320, 420, 520) is integrally formed out of the printed circuit board (11) by at least one cut (17, 117, 217, 317, 417,517) through the printed circuit board (11),
- the at least one holding section (20, 120, 220, 320, 420, 520) is integral with and integrally connected in one piece to the remaining printed circuit board (11),
- the holding section (20, 120, 220, 320, 420, 520) has at least one free holding end region (17, 117, 217, 317, 417, 517),
- the free holding end region (17, 117, 217, 317, 417, 517) is elastically movable relative to the remaining printed circuit board (11) in a direction perpendicular to the surface (12) of the remaining printed circuit board (11),
- the at least one elastically movable holding section (20, 120, 220, 320, 420, 520) of the printed circuit board (11) is displaced or deflected by movement of the printed circuit board (11) with respect to the holding device (26) in the mounted state of the operating device (25) in the electrical domestic or household appliance (BO) when the operating device (25) is mounted in the appliance (BO).

2. Appliance according to claim 1, **characterized in that** the holding section (20, 120, 220, 320, 420, 520) is elongated, in particular with a length, which is at least three times or at least ten times the width of the holding section (20, 120, 220, 320, 420, 520), the free holding end region (17, 117, 217, 317, 417, 517) preferably being provided at the end of the length of the holding section (20, 120, 220, 320, 420, 520).

3. Appliance according to claim 2, **characterized in that** the cut (17, 117, 217, 317, 417, 517) runs in a direction parallel to the longitudinal direction of the holding section (20, 120, 220, 320, 420, 520), preferably the holding section (20, 120, 220, 320, 420, 520) having a constant width along its length.

4. Appliance according to one of the preceding claims, **characterized in that** the holding section (20, 120, 220) is separated from the remaining printed circuit board (11) by means of exactly one single straight cut (17, 117, 217), wherein in particular the single straight cut (17, 117, 217) begins at a free outer edge (15) of the printed circuit board (11) and preferably runs parallel to an angularly adjacent outer edge (15) in such a way that a longitudinal side of the holding section (20, 120, 220) is formed by this outer edge (15).

5. Appliance according to one of the claims 1 to 3, **characterized in that** the holding section (320, 420, 520) is separated from the remaining printed circuit board (11) by at least two cuts (317, 417, 517), the at least two cuts (317, 417, 517) preferably starting at an outer edge (15) of the printed circuit board (11) and in particular being parallel to one another.

6. Appliance according to claim 5, **characterized in that** a holding section (320, 420, 520) with at least two partial holding sections is formed by the at least two cuts (417a, 417b), wherein in particular the holding section has at least as many free cuts (417a, 417b) as partial holding sections.

7. Appliance according to claim 5 or 6, **characterized in that** one (417a) of the two cuts (417a, 417b) is longer than the other cut (417b) and extends with a longitudinal region, extending beyond the other cut (417a), in a curved manner, in particular in a part-circle shape, around a region at the end of the other cut (417b), preferably with a circular angle of at most 180°.

8. Appliance according to one of claims 1 to 3 or 5 to 7, **characterized in that** the holding section (320, 420, 520) is arranged within the surface of the printed circuit board (11) without being connected to an outer edge (15) of the printed circuit board (11) or having a distance of at least 0.5 cm to each of the outer edges (15) of the printed circuit board (11), preferably at least two parallel cuts (317a, 317b, 417a, 417b, 517a, 517b) delimiting the holding section (320, 420, 520) along its longitudinal edges.

9. Appliance according to one of the preceding claims, **characterized in that** the at least one holding section (20, 120, 220, 320, 520) has a substantially rectilinear extension, in particular with a constant width.

10. Appliance according to one of the claims 1 to 8, **characterized in that** the at least one holding section (420) has a rounded curved shape, in particular with a constant width, preferably running around at most an arc angle of 180°.

11. Appliance according to one of the claims 1 to 8, **characterized in that** the at least one holding section is meander-shaped with adjacent and/or parallel partial holding sections which are at a small distance from one another and run in opposite directions.

12. Appliance according to one of the preceding claims, **characterized in that** the printed circuit board (11) has three or four holding sections (20, 120, 220, 320, 420, 520), the printed circuit board (11) preferably being essentially rectangular, and the holding sections (20, 120, 220, 320, 420, 520) being arranged in corner regions of the printed circuit board (11).

## Patentansprüche

1. Elektrisches Haushaltsgerät (BO) mit einer Bedieneinrichtung (25), wobei die Bedieneinrichtung (25) umfasst:
- eine Leiterplatte (11) mit darauf angeordneten elektrischen Bauteilen (14), wobei die Leiterplatte (11) mindestens einen Halteabschnitt (20, 120, 220, 320, 420, 520) aufweist,
- eine Haltevorrichtung (26) für die Leiterplatte (11), wobei die Leiterplatte (11) formschlüssig und fest an der Haltevorrichtung (26) gehalten ist, wobei die Haltevorrichtung (26) an dem mindestens einen Halteabschnitt (20, 120, 220, 320, 420, 520) der Leiterplatte (11) angreift und die Leiterplatte (11) mittels des mindestens einen Halteabschnitts (20, 120, 220, 320, 420, 520) an der Haltevorrichtung (26) gehalten wird,
wobei:
- der mindestens eine Halteabschnitt (20, 120, 220, 320, 420, 520) durch mindestens einen Schnitt (17, 117, 217, 317, 417, 517) durch die Leiterplatte (11) einstückig aus der Leiterplatte (11) ausgebildet ist,
- der mindestens eine Halteabschnitt (20, 120, 220, 320, 420, 520) einstückig mit der verbleibenden Leiterplatte (11) ausgebildet und einstückig mit dieser verbunden ist,
- der Halteabschnitt (20, 120, 220, 320, 420, 520) mindestens einen freien Halteendbereich (17, 117, 217, 317, 417, 517) aufweist,
- der freie Halteendbereich (17, 117, 217, 317, 417, 517) relativ zur übrigen Leiterplatte (11) in einer Richtung senkrecht zur Oberfläche (12) der übrigen Leiterplatte (11) elastisch bewegbar ist,
- das elektrische Haushaltsgerät (BO) eine Abdeckung als Bedienfeld (OP) für die Bedieneinrichtung (25) aufweist,
- das Bedienfeld (OP) eine Vorderseite zur Bedienung und eine Rückseite (US) aufweist,
- die Bedieneinrichtung (25) auf der Rückseite (US) des Bedienfeldes (OP) angeordnet ist,
- der mindestens eine elastisch bewegbare Halteabschnitt (20, 120, 220, 320, 420, 520) der Leiterplatte (11) durch Bewegung der Leiterplatte (11) gegenüber der Haltevorrichtung (26) im montierten Zustand der Bedieneinrichtung (25) im elektrischen Haushaltsgerät (BO) verschoben oder ausgelenkt wird, wenn die Bedieneinrichtung (25) in dem Gerät (BO) montiert ist,
**dadurch gekennzeichnet, dass**
- eine Haltevorrichtung (28) für einen flachen Sensorelementträger (32) auf der Leiterplatte (11) vorgesehen ist,
- der Sensorelementträger (32) parallel zur Leiterplatte (11) und in einem Abstand davon angeordnet ist,
- der Sensorelementträger (32) gegen eine Rückseite (US) der Bedienungsplatte (OP) der Bedieneinrichtung (25) gedrückt ist.

2. Haushaltsgerät nach Anspruch 1, **dadurch gekennzeichnet, dass** der Halteabschnitt (20, 120, 220, 320, 420, 520) länglich ausgebildet ist, insbesondere mit einer Länge, die mindestens das Dreifache oder mindestens das Zehnfache der Breite des Halteabschnitts (20, 120, 220, 320, 420, 520) beträgt, wobei der freie Halteendbereich (17, 117, 217, 317, 417, 517) vorzugsweise am Ende der Länge des Halteabschnitts (20, 120, 220, 320, 420, 520) vorgesehen ist.

3. Haushaltsgerät nach Anspruch 2, **dadurch gekennzeichnet, dass** der Schnitt (17, 117, 217, 317, 417, 517) in einer Richtung parallel zur Längsrichtung des Halteabschnitts (20, 120, 220, 320, 420, 520) verläuft, vorzugsweise wobei der Halteabschnitt (20, 120, 220, 320, 420, 520) entlang seiner Länge eine konstante Breite aufweist.

4. Haushaltsgerät nach einem der vorstehenden Ansprüche, **dadurch gekennzeichnet, dass** der Halteabschnitt (20, 120, 220) durch genau einen einzigen geraden Schnitt (17, 117, 217) von der übrigen Leiterplatte (11) getrennt ist, wobei insbesondere der einzelne gerade Schnitt (17, 117, 217) an einer freien Außenkante (15) der Leiterplatte (11) beginnt und vorzugsweise parallel zu einer winklig benachbarten Außenkante (15) verläuft, so dass eine Längsseite des Halteabschnitts (20, 120, 220) durch diese Außenkante (15) gebildet wird.

5. Haushaltsgerät nach einem der Ansprüche 1 bis 3, **dadurch gekennzeichnet, dass** der Halteabschnitt (320, 420, 520) durch mindestens zwei Schnitte (317, 417, 517) von der übrigen Leiterplatte (11) getrennt ist, wobei die mindestens zwei Schnitte (317, 417, 517) vorzugsweise an einer Außenkante (15) der Leiterplatte (11) beginnen und insbesondere parallel zueinander verlaufen.

6. Haushaltsgerät nach Anspruch 5, **dadurch gekennzeichnet, dass** durch die mindestens zwei Schnitte (417a, 417b) ein Halteabschnitt (320, 420, 520) mit mindestens zwei Teilhalteabschnitten gebildet ist, wobei insbesondere der Halteabschnitt mindestens so viele freie Schnitte (417a, 417b) aufweist wie Teilhalteabschnitte.

7. Haushaltsgerät nach Anspruch 5 oder 6, **dadurch gekennzeichnet, dass** einer (417a) der beiden Schnitte (417a, 417b) länger ist als der andere Schnitt (417b) und sich mit einem Längsbereich, der sich über den anderen Schnitt (417a) hinaus erstreckt, gekrümmt, insbesondere teilkreisförmig, um einen Bereich am Ende des anderen Schnitts (417b) herum erstreckt, vorzugsweise mit einem Kreiswinkel von höchstens 180°.

8. Haushaltsgerät nach einem der Ansprüche 1 bis 3 oder 5 bis 7, **dadurch gekennzeichnet, dass** der Halteabschnitt (320, 420, 520) innerhalb der Oberfläche der Leiterplatte (11) angeordnet ist, ohne mit einer Außenkante (15) der Leiterplatte (11) verbunden zu sein oder einen Abstand von mindestens 0, 5 cm zu jeder der Außenkanten (15) der Leiterplatte (11) aufweist, vorzugsweise mindestens zwei parallele Schnitte (317a, 317b, 417a, 417b, 517a, 517b), die den Halteabschnitt (320, 420, 520) entlang seiner Längskanten begrenzen.

9. Haushaltsgerät nach einem der vorstehenden Ansprüche, **dadurch gekennzeichnet, dass** der mindestens eine Halteabschnitt (20, 120, 220, 320, 520) eine im Wesentlichen geradlinige Erstreckung, insbesondere mit einer konstanten Breite, aufweist.

10. Haushaltsgerät nach einem der Ansprüche 1 bis 8, **dadurch gekennzeichnet, dass** der mindestens eine Halteabschnitt (420) eine abgerundete gekrümmte Form aufweist, insbesondere mit einer konstanten Breite, vorzugsweise um höchstens einen Bogenwinkel von 180° verlaufend.

11. Haushaltsgerät nach einem der Ansprüche 1 bis 8, **dadurch gekennzeichnet, dass** der mindestens eine Halteabschnitt mäanderförmig mit benachbarten und/oder parallelen Teilhalteabschnitten ausgebildet ist, die einen geringen Abstand voneinander aufweisen und in entgegengesetzten Richtungen verlaufen.

12. Haushaltsgerät nach einem der vorstehenden Ansprüche, **dadurch gekennzeichnet, dass** die Leiterplatte (11) drei oder vier Halteabschnitte (20, 120, 220, 320, 420, 520) aufweist, wobei die Leiterplatte (11) vorzugsweise im Wesentlichen rechteckig ist und die Halteabschnitte (20, 120, 220, 320, 420, 520) in Eckbereichen der Leiterplatte (11) angeordnet sind.

## Revendications

1. Appareil électroménager ou domestique (BO) comportant un dispositif de commande (25), le dispositif de commande (25) comprenant :
- une carte de circuit imprimé (11) sur laquelle sont montés des composants électriques (14), la carte de circuit imprimé (11) comportant au moins une section de maintien (20, 120, 220, 320, 420, 520),
- un dispositif de maintien (26) pour la carte de circuit imprimé (11), la carte de circuit imprimé (11) étant maintenue de manière positive et fixe sur le dispositif de maintien (26), le dispositif de maintien (26) s'engageant dans la au moins une section de maintien (20, 120, 220, 320, 420, 520) de la carte de circuit imprimé (11) et la carte de circuit imprimé (11) étant maintenue sur le dispositif de maintien (26) au moyen de la au moins une section de maintien (20, 120, 220, 320, 420, 520),
dans lequel :
- la au moins une section de maintien (20, 120, 220, 320, 420, 520) est formée d'un seul tenant à partir de la carte de circuit imprimé (11) par au moins une découpe (17, 117, 217, 317, 417, 517) à travers la carte de circuit imprimé (11),
- la au moins une section de maintien (20, 120, 220, 320, 420, 520) est solidaire et reliée d'un seul tenant à la carte de circuit imprimé (11),
- la section de maintien (20, 120, 220, 320, 420, 520) comporte au moins une région d'extrémité de maintien libre (17, 117, 217, 317, 417, 517),
- la région d'extrémité de maintien libre (17, 117, 217, 317, 417, 517) est mobile de manière élastique par rapport à la carte de circuit imprimé (11) dans une direction perpendiculaire à la surface (12) de la carte de circuit imprimé (11),
- l'appareil électroménager ou domestique (BO) comporte un couvercle servant de panneau de commande (OP) pour le dispositif de commande (25),
- le panneau de commande (OP) comporte une face avant destinée à la commande et une face arrière (US),
- le dispositif de commande (25) est disposé sur la face arrière (US) du panneau de commande (OP),
- la au moins une section de maintien élastiquement mobile (20, 120, 220, 320, 420, 520) de la carte de circuit imprimé (11) est déplacée ou déviée par le mouvement de la carte de circuit imprimé (11) par rapport au dispositif de maintien (26) lorsque le dispositif de commande (25) est monté dans l'appareil électroménager ou domestique (BO) lorsque le dispositif de commande (25) est monté dans l'appareil (BO),
**caractérisé en ce que** :
- un dispositif de support (28) pour un support d'élément capteur plat (32) est prévu sur la carte de circuit imprimé (11),
- le support d'élément capteur (32) est disposé parallèlement à la carte de circuit imprimé (11) et à distance de celle-ci,
- le support d'élément capteur (32) est pressé contre une face arrière (US) du panneau de commande (OP) du dispositif de commande (25).

2. Appareil selon la revendication 1, **caractérisé en ce que** la section de maintien (20, 120, 220, 320, 420, 520) est allongée, en particulier avec une longueur qui est au moins trois fois ou au moins dix fois la largeur de la section de maintien (20, 120, 220, 320, 420, 520), la zone d'extrémité de maintien libre (17, 117, 217, 317, 417, 517) étant de préférence prévue à l'extrémité de la longueur de la partie de maintien (20, 120, 220, 320, 420, 520).

3. Appareil selon la revendication 2, **caractérisé en ce que** la découpe (17, 117, 217, 317, 417, 517) s'étend dans une direction parallèle à la direction longitudinale de la section de maintien (20, 120, 220, 320, 420, 520), de préférence la section de maintien (20, 120, 220, 320, 420, 520) ayant une largeur constante sur toute sa longueur.

4. Appareil selon l'une des revendications précédentes, **caractérisé en ce que** la section de maintien (20, 120, 220) est séparée du reste de la carte de circuit imprimé (11) au moyen d'une seule découpe droite (17, 117, 217), dans lequel, en particulier, la seule découpe droite (17, 117, 217) commence au niveau d'un bord extérieur libre (15) de la carte de circuit imprimé (11) et s'étend de préférence parallèlement à un bord extérieur angulairement adjacent (15) de telle sorte qu'un côté longitudinal de la section de maintien (20, 120, 220) est formé par ce bord extérieur (15).

5. Appareil selon l'une des revendications 1 à 3, **caractérisé en ce que** la section de maintien (320, 420, 520) est séparée du reste de la carte de circuit imprimé (11) par au moins deux découpes (317, 417, 517), les au moins deux découpes (317, 417, 517) commençant de préférence au niveau d'un bord extérieur (15) de la carte de circuit imprimé (11) et étant en particulier parallèles entre elles.

6. Appareil selon la revendication 5, **caractérisé en ce qu'**une section de maintien (320, 420, 520) avec au moins deux sections de maintien partielles est formée par les au moins deux découpes (417a, 417b), dans lequel en particulier la section de maintien présente au moins autant de découpes libres (417a, 417b) que de sections de maintien partielles.

7. Appareil selon la revendication 5 ou 6, **caractérisé en ce que** l'une (417a) des deux découpes (417a, 417b) est plus longue que l'autre découpe (417b) et s'étend avec une région longitudinale, s'étendant au-delà de l'autre découpe (417a), de manière courbée, en particulier en forme de cercle partiel, autour d'une région à l'extrémité de l'autre découpe (417b), de préférence avec un angle circulaire d'au plus 180°.

8. Appareil selon l'une des revendications 1 à 3 ou 5 à 7, **caractérisé en ce que** la section de maintien (320, 420, 520) est disposée à l'intérieur de la surface de la carte de circuit imprimé (11) sans être reliée à un bord extérieur (15) de la carte de circuit imprimé (11) ou en ayant une distance d'au moins 0, 5 cm par rapport à chacun des bords extérieurs (15) de la carte de circuit imprimé (11), de préférence au moins deux découpes parallèles (317a, 317b, 417a, 417b, 517a, 517b) délimitant la section de maintien (320, 420, 520) le long de ses bords longitudinaux.

9. Appareil selon l'une des revendications précédentes, **caractérisé en ce que** la au moins une section de maintien (20, 120, 220, 320, 520) présente une extension sensiblement rectiligne, en particulier avec une largeur constante.

10. Appareil selon l'une des revendications 1 à 8, **caractérisé en ce que** la au moins une section de maintien (420) présente une forme incurvée arrondie, en particulier avec une largeur constante, s'étendant de préférence sur un angle d'arc d'au plus 180°.

11. Appareil selon l'une des revendications 1 à 8, **caractérisé en ce que** la au moins une section de retenue est en forme de méandre avec des sections de retenue partielles adjacentes et/ou parallèles qui sont à une faible distance les unes des autres et s'étendent dans des directions opposées.

12. Appareil selon l'une des revendications précédentes, **caractérisé en ce que** la carte de circuit imprimé (11) comporte trois ou quatre sections de maintien (20, 120, 220, 320, 420, 520), la carte de circuit imprimé (11) étant de préférence essentiellement rectangulaire, et les sections de maintien (20, 120, 220, 320, 420, 520) étant disposées dans les zones d'angle de la carte de circuit imprimé (11).
